# EUROPEAN PATENT APPLICATION

(11) **EP 2 484 648 A1**
(43) Date of publication of application: **08.08.2012**
(21) Application number: 10818808.7
(22) Date of filing: 22.09.2010
(51) Int. Cl.: C03C 27/12, G02F 1/1333, H01L 31/04

(54) **LAMINATED GLASS SUBSTRATE, PROCESS FOR PRODUCTION OF THE LAMINATED GLASS SUBSTRATE, AND ELECTRONIC DEVICE EQUIPPED WITH THE LAMINATED GLASS SUBSTRATE**

(30) Priority: 28.09.2009 JP 2009223371
(71) Applicant: Asahi Glass Company, Limited, Tokyo 100-8405 (JP)
(72) Inventor: HIGUCHI Toshihiko, Tokyo 100-8405 (JP)
(74) Representative: Müller-Boré & Partner Patentanwälte
(86) International application number: PCT/JP2010/066406
(87) International publication number: WO 2011/037135

(57) **Abstract**

The present invention relates to a laminated glass substrate comprising n pieces of glass film layers (wherein n is an integer of 2 or more) and (n-1) pieces of resin layers which are present between the respective glass film layers, wherein each of the glass film layers has a thickness of 0.01 to 0.1 mm, and each of the resin layers has a thickness less than that of both of the adjacent glass film layers.

## Description

### TECHNICAL FIELD

The present invention relates to a laminated glass substrate having plural glass film layers and an electronic device equipped therewith.

### BACKGROUND ART

In recent years, with the progress in thinning and weight reduction of an electronic device (electronic component) such as organic EL panel, solar cell and thin-film secondary battery, the thickness reduction of the glass substrate for use in such an electronic devices progresses. When the strength of the glass substrates is reduced due to the thickness reduction, handling ability (impact resistance and flexibility) of the glass substrate is impaired. Incidentally, in view of the handling ability, it may be also possible to use resin substrate, in place of the glass substrate. However, the resin substrate has a problem, for example, in scratch resistance and chemical resistance.

Further, it has recently been proposed a laminated glass substrate in which a resin layer (resin film) is provided between two glass films (for example, see Patent Document 1). This laminated glass substrate is excellent in scratch resistance and chemical resistance, compared to the resin substrate, and excellent in handling ability, compared to the glass substrate.

### RELATED ART

### PATENT DOCUMENT

Patent Document 1: JP-A-2003-39597

### SUMMARY OF THE INVENTION

### PROBLEMS THAT THE INVENTION IS TO SOLVE

However, in the laminated glass substrate described in Patent Document 1, no reference is made to the thickness reduction of the laminated glass substrate, and the resin film is thicker than the glass film. The glass film is poorer in handling ability than the resin film, as described above, and has a lower limit in thickness. In the case where the thickness of each glass film is the same, there is a problem that the resin layer thicker than the glass film causes to increase the thickness of the laminated glass substrate.

The present invention has been made by taking the above-mentioned problems into consideration, and an object of the present invention is to provide a laminated glass substrate which is excellent in scratch resistance, chemical resistance and handling ability and can reduce the thickness.

### MEANS FOR SOLVING THE PROBLEMS

In order to solve the above problems, the present invention provides a laminated glass substrate comprising n pieces of glass film layers (wherein n is an integer of 2 or more) and (n-1) pieces of resin layers which are present between the respective glass film layers, wherein
each of the glass film layers has a thickness of 0.01 to 0.1 mm, and
each of the resin layers has a thickness thinner than that of both of the adjacent glass film layers.

Further, n is preferably 3 or more.
The laminated glass substrate preferably has a thickness of 0.4 mm or less.
Each of the resin layers preferably has a thickness of 1 to 50 µm.
Each of the glass film layers has a thickness of 0.01 to 0.05 mm.

Further, the resin layer is preferably a silicone resin layer.
Moreover, the silicone resin is preferably a cured material of an addition reaction type silicone comprising a combination of an organoalkenylpolysiloxane having an alkenyl group and an organohydrogenpolysiloxane having a hydrogen atom bonded to a silicon atom.

Further, the present invention provides an electronic device provided with the above laminated glass substrate.

Further, the present invention provides a method for producing a laminated glass substrate comprising: laminating n pieces of glass films (wherein n is an integer of 2 or more) each of which has a thickness of 0.01 1 to 0.1 mm with (n-1) pieces of curable resin layers intercalated between the respective glass films; and curing the curable resin, wherein
the thickness of each of the curable resin layers is adjusted so that each of the resin layers after curing has a thickness thinner than that of both of the adjacent glass layers.

Further, the curable resin is preferably an addition reaction type silicone comprising a combination of an organoalkenylpolysiloxane having an alkenyl group and an organohydrogenpolysiloxane having a hydrogen atom bonded to a silicon atom.

### ADVANTAGE OF THE INVENTION

According to the present invention, a laminated glass substrate which is excellent in scratch resistance, chemical resistance and handling ability and can reduce the thickness, can be provided. Further, the laminated glass substrate of the present invention has excellent characteristics as a substrate for an electronic device. Furthermore, the process for producing a laminated glass substrate of the present invention is a suitable process as a process for producing a laminated glass substrate in which a glass film layer and a resin layer are fixed to each other, of these laminated glass substrates.

### BRIEF DESCRIPTION OF THE DRAWING

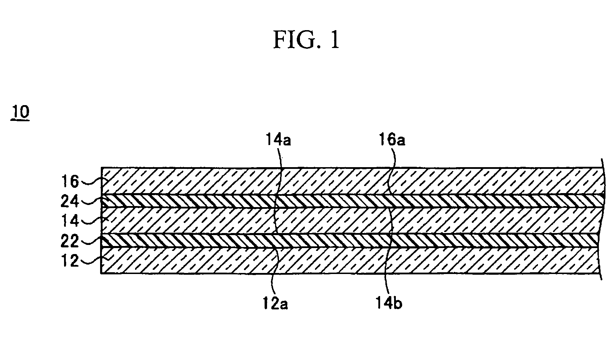

[Fig. 1] Fig. 1 is a cross-sectional view partially showing a laminated glass substrate as one embodiment of the present invention.

### MODE FOR CARRYING OUT THE INVENTION

A mode for carrying out the present invention will be described below with reference to the drawing.

Fig. 1 is a cross-sectional view partially showing a laminated glass substrate as one embodiment of the present invention. The laminated glass substrate 10 has, for example, n pieces of glass film layers 12 to 16, as shown in Fig. 1. Between the adjacent glass film layers 12 and 14 (14 and 16), a resin layer 22 (24) thinner than the respective glass film layers 12 and 14 (14 and 16) is provided.

This laminated glass substrate 10 is excellent in scratch resistance, chemical resistance, moisture permeability resistance, gas barrier properties, surface flatness and the like, compared to the case where at least one outermost layer is the resin layer, because both outermost layers are the glass films.

First, the glass film layers 12 to 16 will be described.

Each of the glass film layers 12 to 16 is made of a glass film obtained by melting a glass raw material and forming the molten glass into a film shape. A forming method may be a general one. For example, a float method, a fusion method, a slot down draw method, a redraw method and the like can be used.

The glass of each of the glass film layers 12 to 16 may be an alkali glass such as an alkali-containing borosilicate glass or a soda lime glass, or may be a non-alkali glass such as a borosilicate glass containing no alkali component. Although it is appropriately selected based on an electronic device to be applied and a production process thereof, the non-alkali glass is preferred because of its low thermal shrinkage.

When the glass of each of the glass film layers 12 to 16 has a high thermal shrinkage, a position gap at the time of cooling of a member for an electronic device (for example, a thin film transistor (TFT)) formed on the laminated glass substrate 10 heated becomes excessive. As an index of the thermal shrinkage, the coefficient of linear expansion specified in JIS R 3102-1995 is used.

The average coefficient of linear expansion at 25 to 300°C (hereinafter simply referred to as "the average coefficient of linear expansion") of the glass of each of the glass film layers 12 to 16 is preferably from 0 to 100×10⁻⁷/°C, more preferably from 0 to 50×10⁻⁷/°C and still more preferably from 0 to 30×10⁻⁷/°C.

Incidentally, in this embodiment, the glass of each of the glass film layers 12 to 16 is preferably the non-alkali glass. However, the alkali glass is preferred in some cases. For example, when the electronic device is a CIGS-based solar cell, the glass of the glass film (for example, the glass film layer 16) on which at least solar cell elements is to be formed is preferably the alkali glass, because it can be utilized as an alkali supply source in a production process of the CIGS-based solar cell.

The plural glass film layers 12 to 16 may be formed of the same material or may be formed of different materials. From the viewpoint of decreasing the difference in the coefficient of linear expansion among the plural glass film layers 12 to 16, they are preferably formed of the same material.

The difference in the average coefficient of linear expansion among the glasses of the plural glass film layers 12 to 16 is preferably 15×10⁻⁷/°C or less. When the difference in the average coefficient of linear expansion among the glasses of the plural glass film layers 12 to 16 is excessively large, there is a possibility of causing a terrific warp of the laminated glass substrate 10 or partial separation of the laminated glass substrate 10 at the time of heating and cooling in a production process and the like of the electronic device.

The thickness of each of the glass film layers 12 to 16 is preferably 0.1 mm or less and more preferably 0.05 mm or less, from the viewpoints of weight reduction, thickness reduction and flexibility. Further, the thickness of each of glass film layers 12 to 16 is preferably 0.01 mm or more, for the reasons of easy production of the glass films, easy handling of the glass films and the like.

The shape of the glass film which forms each of the glass film layers 12 to 16 is not particularly limited and it may be rectangular or strip-shaped. The shapes and dimensions of all glass films which form each of the glass film layers 12 to 16 are preferably nearly the same, from the viewpoint of production cost of the laminated glass substrate 10.

The number n of the glass film layers in the laminated glass substrate is not particularly limited as long as it is 2 or more. It is preferably 3 or more and more preferably 6 or more. When the thickness of the laminated glass substrate is the same, the glass film which forms each of the glass film layers can be made thinner by increasing the number of the glass film layers, thereby being able to enhance flexibility of each glass film. Thanks to this, flexibility of the laminated glass substrate can be enhanced. When the number n of the glass film layers in the laminated glass substrate is too large, production of the laminated glass substrate becomes complicated. Accordingly, the number n of the glass film layers is preferably 30 or less. n is more preferably 20 or less and still more preferably 10 or less.

Next, the resin layers 22 and 24 will be described.

The resin layer 22 (24) is in close contact with or fixed to the glass film layers 12 and 14 (14 and 16) on both sides thereof. The resin layer 22 (24) and each of the glass film layers 12 and 14 (14 and 16) on both sides thereof may be fixed to each other in a manner difficult to be released or may be releasably in close contact with each other.

That is to say, being in close contact means that the resin layer 22 (24) is bonded with a certain degree of bonding force to surfaces 12a and 14a (14b and 16a) of the glass film layers 12 and 14 (14 and 16) which comes into contact with the resin layer, but is bonded with such a degree of bonding force as to be easily separated without exerting an adverse effect on the glass film layers 12 and 14 (14 and 16) at the time of release. For example, it means that at the time of release, the resin layer can be separated without damaging the glass film layers 12 and 14 (14 and 16) and without causing a residual resin on the surfaces of the glass film layers 12 and 14 (14 and 16). On the other hand, the fixing means that bonding force thereof is relatively higher than the bonding force in the case of being in close contact. The fixing means that the resin layer is strongly bonded to the surfaces of the glass film layers by adhesion, sticking or the like. When the resin layer and the surfaces of the glass film layers are fixed to each other, it is usually difficult to separate both layers without causing breakage of the resin layer or the glass film layers.

In the case of being releasably in close contact, relatively weak sticking force of the resin layer 22 (24), van der Waals' force acting between the resin layer 22 (24) and each of the glass film layers 12 and 14 (14 and 16) and the like can be utilized as close contact force.

In the case where at least one resin layer (for example, the resin layer 24) is releasably in close contact with one glass film layer (for example, the glass film layer 16), the resin layer can be released from the glass film layer and brought into close contact with the glass film layer again. Accordingly, in the case where the resin layer and the glass film layer are brought into close contact with each other, when a position gap occurs, position adjustment can be performed again.

Further, in the case where at least one resin layer (for example, the resin layer 24) is releasably in close contact with one glass film layer (for example, the glass film layer 16), when the glass film layer is damaged, the glass film can be replaced.

In particular, as the laminated glass substrate of the present invention, it is preferred that all the glass film layers 12 and 14 (14 and 16) and the resin layer 22 (24) are bonded to each other with high bonding force (namely, fixed to each other). Such a laminated glass substrate can be used as with a conventional monolayer glass substrate, as one corresponding to a sheet of substrate.

From the viewpoints of flexibility and impact resistance, it is preferred that a material of each of the resin layers 22 and 24 contains at least any one of acrylic resins, polyolefin resins, epoxy resins, polyurethane resins and silicone resins. Further, in the case of the laminated glass substrate requiring heat resistance, preferred are heat-resistant resins such as polyimide resins, polyamideimide resins and polyarylene ether- resins. Further, the material of each of the resin layers 22 and 24 may be a thermoplastic resin or a cured material of a curable resin. When the curable resin is used, it is usually cured between the glass films to form the resin layer. Accordingly, preferred is the curable resin which can be cured without producing low-molecular compounds (such as water) as by-products at the time of curing. From the viewpoint of heat resistance, in addition to flexibility and impact resistance, it is more preferred that the material of each of the resin layers 22 and 24 contains the silicone resins. As the silicone-based resin, particularly preferred is a cured material of an addition reaction type silicone described later.

The resins of the respective resin layers 22 and 24 in which the number of layers is (n-1) may be formed of the same material or may be formed of different materials. From the viewpoint of production cost of the laminated glass substrate 10, they are preferably formed of the same material.

Further, the resins of the respective resin layers 22 and 24 may be formed of only one kind of resin or may be formed using two or more kinds of resins. When they are formed using two or more kinds of resins, the two or more kinds of resins may form the resin layer having a multilayer structure in which the resins are laminated on one another or a mixed resin layer containing the two or more kinds of resins in one layer.

The resin layer 22 (24) is formed thinner than each of the glass film layers 12 to 16. As described above, the glass film is poor in handling ability, and has a lower limit in the thickness thereof. For this reason, when the resin layer 22 (24) is thicker than each of the glass film layers 12 to 16, there is a problem that the thickness of the laminated glass substrate 10 becomes thick. Further, when the resin layer 22 (24) becomes thicker than each of the glass film layers 12 to 16, there is a problem that the average coefficient of linear expansion of the laminated glass substrate 10 increases because resins usually have a lager average coefficient of linear expansion than glass.

The thickness of the respective resin layer 22 (24) is preferably from 1 to 50 µm (however, thinner than the thickness of the glass film layers adjacent thereto). When the thickness of the resin layer 22 (24) is thinner than 1 µm, there is a tendency to fail to sufficiently achieve close contact force or fixing force between the resin layer 22 (24) and the glass film layers 12 and 14 (14 and 16) on both sides thereof. On the other hand, when the thickness of the resin layer 22 (24) is thicker than 50 µm, the contribution thereof to improvement of the close contact force or the fixing force is small, and there is a possibility of impairing flexibility or thickness reduction of the laminated glass substrate 10. More preferably, the thickness of the resin layer 22 (24) is from 5 to 20 µm.

The thickness of the laminated glass substrate (namely, the total of the thickness of n pieces of the glass film layers and the thickness of (n-1) pieces of the resin layers, and in the case of the laminated glass substrate 10, the total of the thickness of the glass film layers 12 to 16 and the thickness of the resin layers 22 and 24) is preferably 0.4 mm or less, from the viewpoint of thickness reduction.

When the glass film layers 12 to 16 and the resin layers 22 and 24 are laminated in the laminated glass substrate 10, it is preferred that they are laminated so as to have a symmetrical structure in a lamination direction. Thanks to this, a warp or separation of the laminated glass substrate 10 at the time of heating and cooling can be inhibited.

A production process of the laminated glass substrate will be described below.

The production process of the laminated glass substrate is not particularly limited. The laminated glass substrate can be produced, for example, by processes such as a process of performing lamination with alternating layers of n pieces of glass films and (n-1) pieces of resin films (hereinafter referred to as process A); a process of forming (n-1) pieces of curable resin layers between n pieces of glass films to produce a precursor laminated body, and then, curing the curable resins (hereinafter referred to as process B); and a process of forming a curable resin layer on a surface of a glass film, followed by curing, thereafter, laminating another glass film on a surface of the cured resin layer, and repeating this to produce a laminated body (hereinafter referred to as process C).

As the resin film used in process A, there can be used a thermoplastic resin film or a non-thermoplastic resin film such as a cured material of a curable resin. When the thermoplastic resin film is used, the glass film and the thermoplastic resin film can be heat-fused to each other, to thereby enhance the bonding force of both. When the non-thermoplastic resin film is used, the glass film and the non-thermoplastic resin film are bonded to each other by the above-mentioned close contact force, thereby being able to make them releasable. Further, use of a sticky resin film makes it possible to bond the glass film and the sticky resin film to each other by relatively high bonding force.

Process B is a production process of the laminated glass substrate containing laminating n pieces of the glass films with (n-1) pieces of the curable resin layers intercalated between the respective glass films, and curing the curable resin. For example, there can be used a process of forming a layer of the curable resin on one side of the glass film, laminating (n-1) pieces of the glass films having the curable resin layers and one piece of the glass film having no curable resin layer to produce a precursor laminated body containing n pieces of the glass film layers and (n-1) pieces of the curable resin layers which are present between the respective glass film layers, and then, curing the curable resin to convert the curable resin layers to the resin layers. Further, the curable resin layers are formed on both sides of the glass film, and a similar precursor laminated body can also be produced using the glass films having the curable resin layers on both sides and the glass films having no curable resin layer. In the case of process B, the curable resin is cured in a state where the surface of the glass film is in contact with the curable resin layer, whereby bonding force of bonding at an interface between the glass film layer and the resin layer tends to be high, resulting in the interface of difficult to be released.

As process C, for example, the curable resin layer is formed on one side of one glass film, then, the curable resin is cured to form the resin layer, and thereafter, another glass film is laminated on a surface of the resin layer formed of the cured curable resin to produce a laminated glass substrate having a three-layer structure containing two pieces of the glass film layers and one piece of the curable resin layer. Then, the curable resin layer is formed on a surface of the glass film layer on one side of this laminated glass substrate having the three-layer structure, followed by curing the curable resin to form the resin layer, and thereafter, the glass film is newly laminated on a surface of the resin layer formed of the cured curable resin to produce a laminated glass substrate having five-layer structure containing 3 pieces of the glass film layers and 2 pieces of the curable resin layers. This step is repeated (n-1) times in total to produce the laminated glass substrate formed of n pieces of the glass film layers and (n-1) pieces of the resin layers. In this process C, for bonding at an interface between the glass film layer and the resin layer, which is formed by curing the curable resin in a state where the surface of the glass film is in contact with the curable resin layer, bonding force tends to be high, resulting in the interface difficult to be released. On the other hand, for bonding at an interface between the surface of the resin layer after curing of the curable resin and the glass film layer laminated thereon, bonding force tends to be low, resulting in the releasable interface.

The process for producing the laminated glass substrate is not limited to the above-mentioned processes A to C. For example, the laminated glass substrate in which any number of interfaces at any positions of the laminated glass substrate having (2n-2) interfaces are made releasable and the other interfaces are made difficult to be released can be produced by combining processes A to C. Further, when the elongated glass film is used, the elongated laminated glass substrate can also be continuously produced by the above-mentioned processes A to C or a combination thereof by using the elongated resin film, the fluid curable resin material or the like.

As the laminated glass substrate of the present invention, preferred is the laminated glass substrate in which each glass film layer and each resin layer are bonded to each other by sufficient bonding force difficult to be released. Such a laminated glass substrate is preferably produced by the above-mentioned process B.

As described above, the resin of the resin layer in the laminated glass substrate of the present invention is preferably the silicone resin. The silicone resins include a cured material of a curable liquid silicone, a crosslinked material of a millable silicone and the like. The curable liquid silicone can be classified into a condensation reaction type silicone, an addition reaction type silicone, an ultraviolet curable type silicone, an electron beam curable type silicone and the like by a curing mechanism thereof. However, any type of them can be used. Above all, from the viewpoints of curing properties, heat resistance and no by-product formation, the addition reaction type silicone is preferred.

The addition reaction type silicone is a curable composition which contains a base agent and a crosslinking agent and is cured in the presence of a catalyst such as a platinum-based catalyst. Curing of the addition reaction type silicone is generally accelerated by heating treatment. The base agent of the addition reaction type silicone is preferably composed of a linear organopolysiloxane having an alkenyl group (such as a vinyl group) bonded to a silicon atom (namely, an organoalkenylpolysiloxane), and an organic group other than the alkenyl group is usually preferably a methyl group. The methyl group may be partially substituted with another organic group such as a phenyl group. The alkenyl group may be bonded to a terminal silicon atom of a linear molecule, may be bonded to a silicon atom in a non-terminal position, or may be bonded to both the terminal silicon atom and the silicon atom in a non-terminal position. As the alkenyl group, particularly preferred is a vinyl group. Incidentally, the weight average molecular weight of the organoalkenylpolysiloxane is preferably 50,000 or less. The crosslinking agent of the addition reaction type silicone is preferably composed of a linear organopolysiloxane having a hydrogen atom bonded to a silicon atom (namely, an organohydrogenpolysiloxane), and an organic group bonded to the silicon atom is usually preferably a methyl group. The methyl group may be partially substituted with another organic group such as a phenyl group. The hydrogen atom bonded to a silicon atom may be bonded to a terminal silicon atom of a linear molecule, may be bonded to a silicon atom in a non-terminal position, or may be bonded to both the terminal silicon atom and the silicon atom in a non-terminal position. Incidentally, the weight average molecular weight of the organohydrogenpolysiloxane is preferably 30,000 or less.

The base agent is not particularly limited. Examples thereof include linear organoalkenylpolysiloxanes represented by the following general formulas (1) and (2).

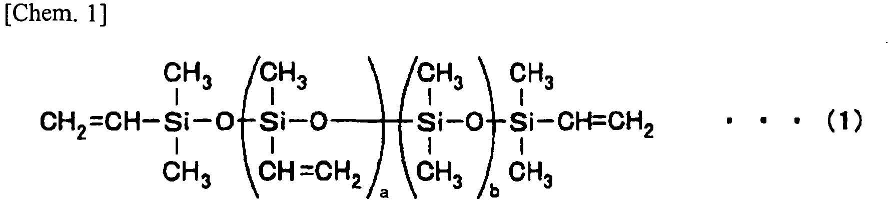

In formula (1), a represents an integer of 0 or more, and b represents an integer of 0 or more. In formula (1), when a is 0, the linear organoalkenylpolysiloxane has vinyl groups only on both terminals. In formula (1), when a is an integer of 1 or more, the organoalkenylpolysiloxane has vinyl groups on both terminals and in side chain(s). Incidentally, a+b is preferably from 0 to 600, and particularly preferably from 0 to 300.

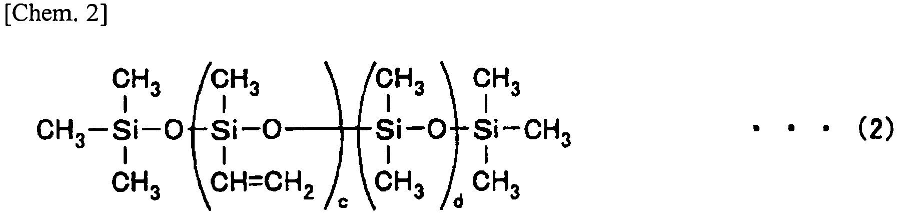

In formula (2), c represents an integer of 2 or more, and d represents an integer of 0 or more. This organoalkenylpolysiloxane has vinyl groups only in side chains. Incidentally, c+d is preferably from 2 to 600, and particularly preferably from 2 to 300.

The crosslinking agent is not particularly limited. Examples thereof include an organohydrogenpolysiloxane represented by the following general formula (3).

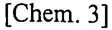

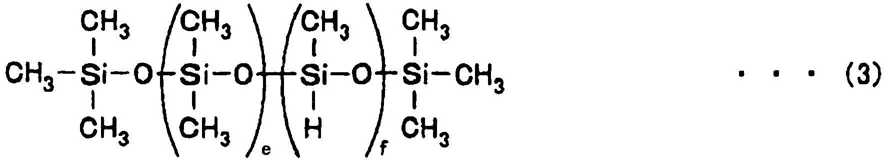

In formula (3), e represents an integer of 0 or more, and f represents an integer of 1 or more. In formula (3), the terminal methyl groups may be partially a hydrogen atom or a hydroxyl group. Incidentally, e+f is preferably from 1 to 400, and particularly preferably from 1 to 200.

Like this, the organohydrogenpolysiloxane that is the crosslinking agent may be one having a hydrogen atom bonded to a silicon atom in an organopolysiloxane chain.

The blending ratio of the above-mentioned base agent and the above-mentioned crosslinking agent is preferably adjusted so that the molar ratio of hydrogen atoms bonded to silicon atoms of the crosslinking agent to vinyl groups of the base agent becomes 0.5 to 2.

As the catalysts, examples thereof include platinum-based catalysts such as chloroplatinic acids such as chloroplatinous acid and tetrachloroplatinic acid, alcohol compounds and aldehyde compounds of chloroplatinic acid, and chain salts of chloroplatinic acid and various olefins.

The amount of the catalyst to be used is adjusted preferably to 0.1 to 20 parts by mass and more preferably to 1 to 10 parts by mass, based on 100 parts by mass of the addition reaction type silicone (namely, 100 parts by mass in total of the organoalkenylpolysiloxane and the organohydrogenpolysiloxane).

Curing conditions of the addition reaction type silicone are appropriately set depending on the amount of the catalyst to be used and the like. For example, when the platinum-based catalyst is used in an amount of 2 parts by mass based on 100 parts by mass of the addition reaction type silicone, heating treatment is preferably performed at a temperature of 50 to 250°C for 5 to 60 minutes. A more preferred treatment temperature is from 100 to 200°C. A more preferred treatment time is form 10 to 30 minutes.

In the production of the laminated glass substrate, as the curable liquid silicone, any one of a solvent type, an emulsion type, a non-solvent type and the like can be used. Above all, the non-solvent type one is preferred from the viewpoints of productivity, safety and environmental friendliness. When the non-solvent type one is used, foams are difficult to remain in each resin layer, because any solvent that causes foaming at the time of curing is not contained therein.

In process A of the above-mentioned production processes of the laminated glass substrate, the silicone resin film can be used. Methods for forming the silicone resin film include a method of applying the curable liquid silicone onto a substrate having a releasable surface (hereinafter referred to as a releasable substrate), curing it, and thereafter, separating it from the substrate to produce the silicone resin film. It is only necessary that the releasable substrate onto which the curable liquid silicone is to be applied has smoothness and rigidity enough to form the curable liquid silicone into a film shape. Examples thereof include a sheet formed of a non-adhesiveness plastic material such as a fluororesin, and a sheet formed of a metal, plastic or glass, a surface of which is made releasable by surface treatment or the like.

The silicone resin layer bonded to the surface of the glass film by high bonding force (namely, difficult to be released) is formed by curing the curable liquid silicone in a state where it is in contact with the surface of the glass film. In the above-mentioned process B, the laminated glass substrate in which the silicone resin layers are bonded to the glass film layers by high bonding force is produced by producing the precursor laminated body having the curable liquid silicone layers not cured, and thereafter, curing the curable liquid silicone.

A method for applying the curable liquid silicone to the glass film or releasable substrate is not particularly limited. There are spray coat method, die coat method, spin coat method, dip coat method, roll coat method, bar coat method, screen printing method, gravure coat method and the like, and the method is appropriately selected depending on the kind of the curable liquid silicone. In the case of the non-solvent type, die coat method, spin coat method and screen printing method are suitable.

In order to control the thickness of the resin layer formed of the silicone resin or the thickness of the silicone resin film, the amount of the curable liquid silicone applied onto the surface of the glass film or the releasable substrate can be appropriately adjusted. When the addition reaction type silicone of the non-solvent type is applied onto the substrate, the amount thereof applied is preferably from 1 to 50 g/m², and more preferably from 5 to 20 g/m².

The case where the resin layer 22 (24) is formed of the silicone-based resin which is the cured material of the addition reaction type silicone will be further described below with reference to the drawing.

In producing the laminated glass substrate 10, it is preferred to clean the surfaces of the glass films serving the surfaces 12a and 14a (14b and 16a) of the glass film layers, which is to come into contact with the resin layers 22 (24) formed of the silicone-based resin. When foreign matter such as particles or organic matter remains on the surfaces of the glass films, which is to come into contact with the resin layers, surface flatness of the laminated glass substrate 10 is impaired in some cases.

A cleaning method may be a common treatment used for cleaning of glass surfaces. For example, there are ultrasonic cleaning; ceria polishing using ceria abrasive; acid cleaning using hydrofluoric acid, nitric acid or the like; alkali cleaning using ammonia or potassium hydroxide; cleaning using a surfactant (including a detergent); photochemical cleaning using ultraviolet light or ozone; physical cleaning using plasma; and the like. These cleaning methods are used either alone or in combination. After the cleaning is finished, drying is performed so that no cleaning agent remains, as needed.

In the process of laminating the laminated glass substrate using the silicone resin films (such as the above-mentioned process A), it is preferred to cover both surfaces of each silicone resin film with protecting sheets until just before lamination. This can prevent particles and the like from adhering to both surfaces of the silicone resin film. Incidentally, the protecting sheets are separated at the time of lamination.

In the process using the silicone resin films, the adjacent glass films and the silicone resin film disposed therebetween may be laminated using a roller or a press. This can enhance close contact properties between the adjacent glass films and the silicone resin film disposed therebetween. Incidentally, the lamination is preferably performed in an environment having a high degree of cleanness.

In the process using the silicone resin films, films of a post-crosslinkable silicone resin may be used, and the silicone resin may be post-crosslinked after lamination. This can enhance bonding force between the glass film layers 12 and 14 (14 and 16) and the silicone resin layer 22 (24).

In the process using the curable liquid silicone (such as the above-mentioned process B or C), the curable liquid silicone is applied onto one glass film of the adjacent glass films, and cured to form the resin layer 22 (24). In the case of the addition reaction type silicone, for example, the addition reaction type silicone is applied onto one glass film of the glass films serving the adjacent glass film layers 12 and 14 (14 and 16), and then, subjected to heat treatment, thereby curing it by heating. The other glass film may be laminated before curing by heating (in the case of process B), or the other glass film may be laminated after curing by heating (in the case of process C).

When the other glass film is laminated before curing by heating (in the case of process B), the resin layer 22 (24) is chemically bonded to the other glass film layer and bonded with high bonding force difficult to be released. On the other hand, when the other glass film is laminated after curing by heating (in the case of process C), the resin layer 22 (24) and the other glass film layer are releasably in close contact with each other.

Thus, the laminated glass substrate 10 shown in Fig. 1 can be obtained. The resulting laminated glass substrate 10 is suitably used in electronic devices such as display panels, solar cells and thin-film secondary cells.

A production method of a liquid crystal display panel (LCD) using the laminated glass substrate 10 will be described below. Incidentally, a production method of a TFT-LCD is described in this embodiment. However, the present invention may be applied to a production method of an STN-LCD, and there is no limitation on the kind or type of liquid crystal display panel.

The production method of the liquid crystal display panel contains (1) a TFT substrate production process of forming a thin-film transistor (TFT) on one laminated glass substrate 10, (2) a CF substrate production process of forming a color filter (CF) on another laminated glass substrate 10, and (3) a filter lamination process of laminating on each other the laminated glass substrate 10 on which the thin-film transistor is formed and the laminated glass substrate 10 on which the color filter is formed.

In the TFT substrate production process and the CF substrate production process, well-known photo-lithography techniques, etching techniques or the like are used.

In the filter lamination process, liquid crystals are injected between the laminated glass substrate 10 on which the thin-film transistor is formed (hereinafter referred to as the "laminated glass substrate 10A") and the laminated glass substrate 10 on which the color filter is formed (hereinafter referred to as the "laminated glass substrate 10B") to perform lamination. As a method for injecting the liquid crystals, there is, for example, a reduced-pressure injection method or a drop injection method.

In the reduced-pressure injection method, for example, both laminated glass substrates 10A and 10B are stuck together using a seal material and a spacer material in such a manner that the thin-film transistor and the color filter face each other, and cut into plural cells. The internal pressure of each cell cut is reduced, the liquid crystals are injected into the inside of each cell from an injection hole, and the injection hole is sealed. Subsequently, a polarization plate is attached to each cell, and a backlight and the like are incorporated therein, thereby producing the liquid display panel.

In the drop injection method, for example, the liquid crystals are previously dropped to either one of the laminated glass substrates 10A and 10B, the both laminated glass substrates 10A and 10B are laminated using a seal material and a spacer material in such a manner that the thin-film transistor and the color filter face each other, and cut into plural cells. Subsequently, a polarization plate is attached to each cell, and a backlight and the like are incorporated therein, thereby producing the liquid display panel.

Incidentally, in this embodiment, one laminated glass substrate 10 is used in each of the production of the TFT substrate and the CF substrate. However, the present invention is not limited thereto. That is to say, the laminated glass substrate 10 may also be used in the production of only either one of the TFT substrate and the CF substrate.

A production method of an organic EL display panel (OLED) using the laminated glass substrate 10 will be described below.

The production method of the organic EL display panel contains a process of forming an organic EL element on the laminated glass substrate 10. In this process, well-known vapor deposition techniques, sealing techniques and the like are used. The organic EL element may have a common structure, and contains, for example, a transparent electrode layer, a hole transport layer, a light-emitting layer, an electron transport layer and the like which are sequentially laminated on the laminated glass substrate 10.

The display panel such as the liquid crystal display panel or the organic EL display panel thus produced using the laminated glass substrate 10 has no particular limitation on its use, and is suitably used, for example, in potable electronic devices such as cellular phones, PDAs (personal digital assistances), digital cameras and game devices.

A production method of a solar cell using the laminated glass substrate 10 will be described below.

The production method of the solar cell contains a process of forming a solar cell element on the laminated glass substrate 10. In this process, well-known photo-lithography techniques, film-forming techniques, vapor deposition techniques, sealing techniques, and the like are used. The solar cell element may have a common structure.

In the case of a thin-film silicon solar cell, the solar cell element contains, for example, a transparent electrode layer, a semiconductor layer formed of amorphous silicon and amorphous silicon germanium, a back surface electrode layer and the like which are sequentially laminated on the laminated glass substrate 10.

In the case of a dye-sensitized solar cell, the solar cell element contains, for example, a transparent electrode layer, an electrolyte solution layer using an electrolyte solution, a back surface electrode layer and the like which are sequentially laminated on the laminated glass substrate 10.

In the case of an organic thin-film solar cell, the solar cell element contains, for example, a transparent electrode layer, a semiconductor layer formed of an organic p-type semiconductor and an organic n-type semiconductor, a back surface electrode layer and the like which are sequentially laminated on the laminated glass substrate 10.

A production method of a thin-film secondary cell using the laminated glass substrate 10 will be described below.

The production method of the thin-film secondary cell contains a process of forming a thin-film secondary cell element on the laminated glass substrate 10. In this process, a well-known photo-lithography techniques and the like are used. The thin-film secondary cell element may have a common structure, and contains, for example, a first electric collector layer, a positive electrode layer, a solid electrolyte layer, a negative electrode layer, a second electric collector layer and the like which are sequentially laminated on the laminated glass substrate 10.

### EXAMPLES

The present invention will be specifically described below by way of examples, but the present invention is not construed as being limited by the following examples.

### (Example 1)

In Example 1, three pieces of glass films (manufactured by Asahi Glass Co., Ltd., AN100) having a length of 100 mm, a width of 20 mm, a thickness of 0.1 mm, and an average coefficient of linear expansion of 38×10⁻⁷/°C were prepared. These three pieces of glass films were cleaned with pure water, and then, a mixture of 100 parts by mass of a non-solvent addition reaction type silicone (manufactured by Shin-Etsu Silicone Co., Ltd., KNS-320A) and 2 parts by mass of a platinum-based catalyst (manufactured by Shin-Etsu Silicone Co., Ltd., CAT-PL-56) was applied onto each of the two pieces of glass films by a spin coater (the amount applied: 10 g/m²).

The above-mentioned non-solvent addition reaction type silicone contains a linear organoalkenylpolysiloxane (base agent) having a vinyl group and a methyl group which are bonded to a silicon atom, and a linear organohydrogenpolysiloxane (crosslinking agent) having a hydrogen atom and a methyl group which are bonded to a silicon atom.

Then, the three pieces of glass films were laminated in such a manner that the above-mentioned mixture was disposed between the adjacent glass films, and this laminated body was cured by heating in the atmosphere at 180°C for 10 minutes to obtain the laminated glass substrate 10 shown in Fig. 1. The thickness of the resulting laminated glass substrate 10 was 0.38 mm, and the thickness of the respective resin layers 22 and 24 was 0.04 mm.

For flexibility of this laminated glass substrate 10, the following evaluation was performed. First, after the laminated glass substrate 10 was gently curved, one longitudinal end thereof was fixed, and the other longitudinal end thereof was movably fixed. Next, the appearance of the laminated glass substrate 10 was visually observed while gradually moving the other longitudinal end in a direction coming close to the one longitudinal end, and the minimum bending radius at the time when no breakage occurred was measured. As a result of evaluation, the minimum bending radius of the laminated glass substrate 10 was 93 mm.

### (Example 2)

In Example 2, six pieces of glass films (manufactured by Asahi Glass Co., Ltd., AN100) having a length of 100 mm, a width of 20 mm, a thickness of 0.05 mm, and an average coefficient of linear expansion of 38×10⁻⁷/°C were prepared, and these six pieces of glass films were cleaned with pure water. Thereafter, the addition reaction type silicone mixture used in Example 1 was applied onto each of the five pieces of glass films by a spin coater (the amount applied: 5 g/m²) in the same manner as in Example 1.

Then, the six pieces of glass films were laminated in such a manner that the above-mentioned mixture was disposed between the adjacent glass films, and this laminated body was cured by heating in the atmosphere at 180°C for 10 minutes to obtain a laminated glass substrate. The thickness of the resulting laminated glass substrate was 0.40 mm, and the thickness of the respective resin layers was 0.02 mm.

For flexibility of this laminated glass substrate, the same evaluation as in Example 1 was performed. As a result of the evaluation, the minimum bending radius of the laminated glass substrate was 35 mm. From this result, it was shown that when the number of glass films used in the laminated glass substrate was 6 or more, flexibility was significantly improved.

### (Comparative Example 1)

In Comparative Example 1, a glass substrate (manufactured by Asahi Glass Co., Ltd., AN 100) having a length of 100 mm, a width of 20 mm, a thickness of 0.4 mm and an average coefficient of linear expansion of 38×10⁻⁷/°C was prepared. For flexibility of this glass substrate, the same evaluation as in Example 1 was performed. As a result of evaluation, the minimum bending radius of the glass substrate was 217 mm. From this result, it was shown that the laminated glass substrates of Examples 1 and 2 were significantly improved in flexibility, compared to the conventional glass substrate.

While the present invention has been described in detail with reference to particular embodiments thereof, it will be apparent to one skilled in the art that various changes and modifications can be made therein without departing from the spirit and scope of the present invention.

This application is based on Japanese Patent Application No. 2009-223371 filed on September 28, 2009, and the contents of which are incorporated herein by reference.

### DESCRIPTION OF REFERENCE NUMERALS AND SIGNS

10: Laminated glass substrate
12 to 16: Glass film layers
22 to 24: Resin Layers

## Claims

1. A laminated glass substrate comprising n pieces of glass film layers (wherein n is an integer of 2 or more) and (n-1) pieces of resin layers which are present between the respective glass film layers, wherein
each of the glass film layers has a thickness of 0.01 to 0.1 mm, and
each of the resin layers has a thickness thinner than that of both of the adjacent glass film layers.

2. The laminated glass substrate according to claim 1, wherein n is 3 or more.

3. The laminated glass substrate according to claim 1 or 2, wherein the laminated glass substrate has a thickness of 0.4 mm or less.

4. The laminated glass substrate according to any one of claims 1 to 3, wherein each of the resin layers has a thickness of 1 to 50 µm.

5. The laminated glass substrate according to any one of claims 1 to 4, wherein each of the glass film layers has a thickness of 0.01 to 0.05 mm.

6. The laminated glass substrate according to any one of claims 1 to 5, wherein the resin layer is a silicone resin layer.

7. The laminated glass substrate according to claim 6, wherein the silicone resin is a cured material of an addition reaction type silicone comprising a combination of an organoalkenylpolysiloxane having an alkenyl group and an organohydrogenpolysiloxane having a hydrogen atom bonded to a silicon atom.

8. An electronic device provided with the laminated glass substrate according to any one of claims 1 to 7.

9. A method for producing a laminated glass substrate comprising: laminating n pieces of glass films (wherein n is an integer of 2 or more) each of which has a thickness of 0.01 to 0.1 mm with (n-1) pieces of curable resin layers intercalated between the respective glass films; and curing the curable resin, wherein
the thickness of each of the curable resin layers is adjusted so that each of the resin layers after curing has a thickness thinner than that of both of the adjacent glass layers.

10. The method for producing a laminated glass substrate according to claim 9,
wherein the curable resin is an addition reaction type silicone comprising a combination of an organoalkenylpolysiloxane having an alkenyl group and an organohydrogenpolysiloxane having a hydrogen atom bonded to a silicon atom.
